# FASCICULE DE BREVET EUROPEEN

(11) **EP 0 933 812 B1**
(45) Date de publication et mention de la délivrance du brevet: **07.03.2007**
(21) Numéro de dépôt: 98410153.5
(22) Date de dépôt: 29.12.1998
(51) Int. Cl.: H01L 21/768, H01L 21/288

(54) **Electroplacage d'éléments conducteurs dans un circuit intégré**
Elektrochemische Abscheidung von Metallen in Halbleiteranordnungen
Electroplating of conducting elements in integrated circuits

(30) Priorité: 30.12.1997 FR 9716855
(43) Date de publication de la demande: 04.08.1999
(73) Titulaire: STMicroelectronics S.A., 92120 Montrouge (FR); COMMISSARIAT A L'ENERGIE ATOMIQUE, 75015 Paris Cédex 15 (FR); FRANCE TELECOM, 75015 Paris (FR)
(72) Inventeur: Moussavi, Mehdi, 38700 Corenc (FR); Morand, Yves, 38000 Grenoble (FR)
(74) Mandataire: de Beaumont, Michel

(56) Documents cités:
- EP-A- 0 144 752
- US-A- 5 098 860
- US-A- 5 474 651

## Description

La présente invention concerne la fabrication d'interconnexions à l'intérieur de circuits intégrés. En particulier, elle concerne la fabrication d'interconnexions formées dans des cavités gravées dans une couche diélectrique formée au préalable, ce procédé étant couramment appelé "damascène".

Dans les procédés de formation d'interconnexions connus de type damascène, un motif de cavités est formé dans une couche diélectrique pour correspondre à un motif requis d'interconnexions et de contacts formés ultérieurement. Un métal ou autre matériau conducteur est déposé sur toute la surface de la tranche selon une épaisseur suffisante pour remplir toute les cavités dans la couche diélectrique. Une étape de polissage mécanique ou mécano-chimique est alors appliquée à la tranche pour enlever le matériau conducteur autre que celui situé dans les cavités. Ce polissage est la seule façon d'obtenir une surface supérieure presque parfaitement plane, les interconnexions et les contacts affleurant au niveau de la surface supérieure du diélectrique.

Toutefois, le polissage par enlèvement du métal est indésirable car il faut une longue durée pour enlever une couche métallique épaisse, ce qui augmente la durée totale nécessaire pour la fabrication d'un circuit intégré.

Le brevet US 5 098 860 décrit un procédé de remplissage électrolytique de tranchées qui nécessite une étape de photogravure au fond des tranchées.

Un objet de la présente invention est de prévoir un procédé pour former des interconnexions et des contacts de type damascène dans des circuits intégrés, en réduisant ou en éliminant l'exigence de polissage du matériau conducteur.

Un autre objet de la présente invention est de prévoir un procédé nouveau pour former des contacts et des interconnexions dans des circuits intégrés.

Un autre objet de la présente invention est de prévoir un tel procédé qui fournisse facilement des contacts et des interconnexions ayant des surfaces supérieures sensiblement coplanaires avec les couches diélectriques environnantes.

Ainsi, la présente invention prévoit un procédé de formation d'éléments conducteurs dans un circuit intégré comprenant les étapes successives suivantes :
a) prévoir une couche sous-jacente (10) ayant une surface supérieure ;
b) déposer une première couche diélectrique (14) sur la surface supérieure de la couche sous-jacente ;
c) déposer une première couche conductrice (16) sur la surface supérieure de la première couche diélectrique ; et
d) déposer une seconde couche diélectrique (18) sur la première couche conductrice ;
e) former des cavités (20) traversant la première couche conductrice (16) et la seconde couche diélectrique, 18) et s'étendant au moins partiellement à travers la première couche diélectrique (14) à des emplacements (12) choisis pour la formation d'éléments conducteurs ; et
f) former une seconde couche conductrice (22) sur toutes les surfaces internes des cavités ; et
g) déposer électrolytiquement un autre matériau conducteur (26) sur la seconde couche conductrice pour remplir les cavités.

Selon un mode de réalisation de la présente invention, l'autre matériau conducteur est déposé selon une épaisseur suffisante pour remplir sensiblement les cavités.

Selon un mode de réalisation de la présente invention, l'étape f) comprend les étapes consistant à déposer une seconde couche conductrice sur toutes les surfaces exposées de la structure ; et enlever la seconde couche conductrice de toute les surfaces de la structure autre que les surfaces internes des cavités.

Selon un mode de réalisation de la présente invention, la seconde couche conductrice est enlevée par une étape de polissage.

Selon un mode de réalisation de la présente invention, il est prévu, après l'étape g), l'étape consistant à polir la surface supérieure de la structure pour enlever le matériau conducteur en excès faisant saillie au-dessus de la surface supérieure de la seconde couche diélectrique.

Selon un mode de réalisation de la présente invention, il est prévu, après l'étape g), l'étape consistant à polir la surface supérieure de la structure pour enlever le matériau conducteur faisant saillie au-dessus de la surface supérieure de la première couche diélectrique et pour enlever complètement la seconde couche diélectrique et la première couche conductrice.

Selon un mode de réalisation de la présente invention, la couche sous-jacente est une couche conductrice ou semiconductrice et les cavités s'étendent complètement à travers la première couche diélectrique, d'où il résulte que l'élément conducteur résultant est en contact avec la couche conductrice ou semiconductrice sous-jacente.

Selon un mode de réalisation de la présente invention, les cavités s'étendent seulement partiellement à travers la première couche diélectrique, l'élément conducteur résultant étant isolé électriquement de la couche sous-jacente.

Selon un mode de réalisation de la présente invention, la couche sous-jacente est une couche diélectrique comprenant des éléments de contact qui la traversent verticalement, les cavités s'étendant complètement à travers la première couche diélectrique, d'où il résulte que les éléments conducteurs résultant sont des interconnexions électriquement en contact avec les éléments de contact sous-jacents.

Un mode de réalisation de la présente invention va maintenant être décrit à titre d'exemple en faisant référence aux dessins joints parmi lesquels :
les figures 1 à 4 représentent une partie d'un circuit intégré à diverses étapes d'un procédé de formation de contacts selon la présente invention, avant une étape de dépôt électrolytique ;
la figure 5 représente une tranche semiconductrice subissant une étape de dépôt électrolytique ;
la figure 6 représente en détail une partie d'une tranche semiconductrice montée dans un support mécanique utilisé pour un dépôt électrolytique ;
les figures 7 à 9 représentent une partie d'un circuit intégré à diverses étapes d'un procédé de formation de contacts selon la présente invention, après le dépôt électrolytique ;
la figure 10 représente une structure de contact selon un deuxième mode de réalisation de l'invention ;
la figure 11 représente une structure de contact et d'interconnexion selon un troisième mode de réalisation de la présente invention ; et
la figure 12 représente une structure de connexion selon un quatrième mode de réalisation de la présente invention.

Dans les figures certaines dimensions ont été augmentées par souci de clarté, comme cela est classique dans le domaine de la représentation des circuits intégrés.

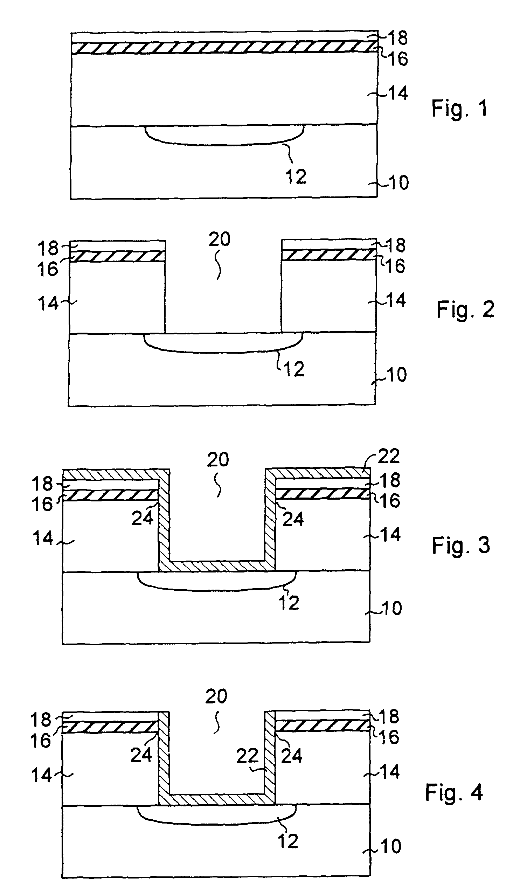

La figure 1 représente une partie d'un circuit intégré semiconducteur en cours de fabrication. Tous les composants semiconducteurs ont été formés. Les structures de contacts et d'interconnexions doivent être formées, convenablement isolées les unes des autres et du semiconducteur.

Un substrat semiconducteur 10 comprend une région de contact 12 qui est un emplacement choisi pour la formation d'un élément conducteur tel qu'un contact. La région de contact peut correspondre par exemple à une région dopée du substrat telle qu'une source ou un drain de transistor dans un circuit intégré MOS. Elle pourrait à titre de variante correspondre à tout autre type de composant disponible dans un circuit intégré. En particulier, elle pourrait être remplacée par une couche de silicium polycristallin ou autre matériau conducteur, tel qu'un siliciure, ou bien en contact électrique avec le substrat 10 ou bien isolée de celui-ci.

Une première couche diélectrique 14 est déposée sur toute la surface de la structure. L'épaisseur de la première couche diélectrique est déterminée selon l'épaisseur requise d'un élément conducteur achevé.

Selon un aspect de la présente invention, une première couche conductrice mince 16 est déposée sur la première couche diélectrique 14 et une seconde couche diélectrique 18 est déposée sur la première couche conductrice. Aucune des couches 14, 16, 18 n'est gravée à cette étape. La première couche conductrice peut être une couche métallique d'une épaisseur de 100 nm déposée à basse température. Elle est de préférence en aluminium du fait de la faible résistivité de l'aluminium et de la faible température à laquelle il peut être déposé. Une faible température de dépôt est particulièrement avantageuse si des couches diélectriques à faible perméabilité (ε) sont utilisées, étant donné que celles-ci peuvent être instables à haute température. Une couche de titane ou de nitrure de titane peut être utilisée bien qu'une telle couche puisse être trop résistive. Le cuivre a des caractéristiques similaires à celle de l'aluminium mais peut être difficile à graver ensuite et peut provoquer des contaminations. Le tungstène est facile à former et à graver, et est un métal couramment utilisé pour la fabrication des circuits intégrés, mais présente une forte résistivité.

Comme cela est représenté en figure 2, une cavité 20 est gravée dans chaque région de contact. La cavité peut être formée en une seule étape de gravure en utilisant des produits d'attaque non sélectifs pour les matériaux des couches 14, 16, 18, ou bien la cavité peut être formée en plusieurs étapes quand on utilise des produits d' attaque sélectifs quant aux matériaux des couches 14, 16, 18. En tout cas, il faut utiliser une gravure fortement anisotrope étant donné que la cavité 20 doit avoir des parois sensiblement verticales et aussi lisses que possible. On peut envisager l'utilisation d'un procédé mécanique pour former la cavité 20. Le meulage ionique peut être un procédé mécanique approprié.

Selon un aspect de l'invention, des parties de la première couche conductrice 16 sont exposées à l'intérieur de la cavité 20, mais la première couche conductrice est par ailleurs recouverte de la seconde couche diélectrique 18.

Comme cela est représenté en figure 3, une seconde couche conductrice mince 22 est déposée sur toutes les surfaces exposées de la structure, en particulier sur les surfaces intérieures de la cavité 20. La seconde couche conductrice est en conséquence en contact électrique avec la première couche conductrice 16 au niveau de régions de continuité 24 autour de la périphérie de chaque cavité 20. La seconde couche conductrice doit avoir une résistance relativement faible, étant donné qu'elle constitue une interface avec la région de contact 12. Des matériaux convenables sont le titane et le nitrure de titane déposés selon une épaisseur de 20 à 60 nm par un procédé de pulvérisation. Une couche de cuivre peut être déposée, mais à nouveau ceci peut provoquer des problèmes de diffusion ou de contamination. On préfère ne pas utiliser de silicium polycristallin en raison de sa forte résistivité et de la température élevée requise pour son dépôt. D'autres matériaux et épaisseurs peuvent être utilisés, pourvu toujours que la couche 22 soit électriquement continue sur toutes les surfaces internes de la cavité 20. A cette étape, toutes les régions de contact du circuit intégré sont électriquement connectées les unes aux autres par la deuxième couche conductrice 22 et par la première couche conductrice 16.

Comme cela est représenté en figure 4, la seconde couche conductrice 22 est enlevée de la structure ailleurs qu'à l'intérieur des cavités 20. Ceci peut être réalisé par une étape de polissage mécanique ou mécano-chimique ou tout autre procédé approprié. Etant donné que la seconde couche conductrice 22 est relativement mince, cette étape de polissage peut être brève par rapport à la durée nécessaire aux étapes de polissage décrites en relation avec l'état de la technique.

La surface exposée de la structure comprend maintenant un matériau isolant 18 dans toutes les zones autres qu'à l'intérieur des cavités 20, les cavités contenant un revêtement exposé de matériau conducteur 22, tous ces revêtements étant reliés les uns aux autres par la première couche conductrice 16.

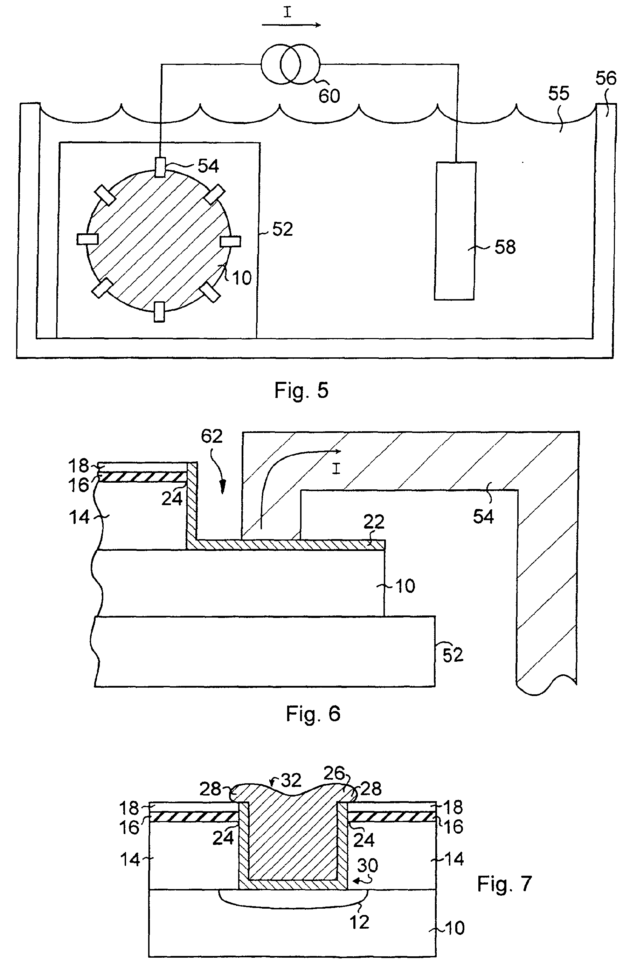

Une étape de dépôt électrolytique est alors réalisée. La figure 5 représente un tel agencement.

Le substrat semiconducteur 10, sous forme d'une tranche est monté sur un support mécanique 52 par des pinces 54. Le support mécanique et la tranche 10 sont immergés dans un électrolyte 55 contenu dans un bain électrolytique 56. Une électrode 58 est également placée dans le bain électrolytique. Au moins les revêtements de matériau conducteur 22 sont électriquement connectés à une borne d'une source de courant 60. Une seconde borne de la source de courant est reliée à l'électrode 58. La source de courant 60 fait passer un courant dans l'électrolyte 55. Selon la composition de l'électrolyte 55, un matériau conducteur est déposé sur toutes les surfaces exposées de la tranche 10 qui sont électriquement conductrices et connectées à la source de courant. Comme le représente la figure 4, seuls les revêtements de matériau conducteur 22 satisfont à ce critère. En conséquence, du matériau conducteur se dépose seulement dans les cavités 20.

La valeur du courant I et la durée pendant laquelle le courant est appliqué sont fixées de sorte que les cavités se remplissent de matériau conducteur, sans remplissage excessif.

Un bain électrolytique approprié est une solution de 17 grammes par litre de sulfate de cuivre (CuSO₄) dans une solution tampon acide, par exemple à 10% d'acide sulfurique (H₂SO₄). En faisant passer un courant de 8 A pendant 3 à 4 minutes, du cuivre conducteur se dépose sur une épaisseur d'environ 1,5 µm. La tranche est polarisée négativement tandis que l'électrode 58 (l'anode) est de préférence constituée de cuivre pour assurer que les ions de cuivre de l'électrolyte, consommés par le dépôt du cuivre sur la tranche 10 sont renouvelés.

Le dépôt électrolytique peut être effectué tranche par tranche, ou sur un lot de tranches, pourvu que des connexions électriques appropriées soit assurées sur chaque tranche.

La figure 6 représente en détail une pince 54 utilisée pour maintenir la tranche 10 contre le support mécanique 52 tout en assurant un contact électrique avec une zone de contact d'électrode 62. La zone de contact d'électrode 62 est une cavité agrandie s'étendant jusqu'au bord de la tranche 10. Elle peut avoir des dimensions de plusieurs mm. Elle est formée de la même façon que la cavité de la figure 4. La cavité agrandie contient un revêtement de matériau conducteur 22, mais est ouverte au bord de la tranche. Comme dans toutes les autres cavités, le revêtement est en contact électrique avec la première couche conductrice 16 au niveau d'une région de continuité 24.

La pince 54 est constituée d'un matériau électriquement conducteur en contact avec le revêtement 22 de la zone de contact 62. En reliant la pince 54 à la source de courant 60, tous les revêtements des cavités sur la tranche 10 sont polarisés et peuvent servir de site de dépôt dans le processus de dépôt électrolytique.

Bien qu'une seule pince 54 et une seule zone de contact 62 suffisent à assurer la conductivité électrique nécessaire, le dépôt électrolytique résultant pourrait être irrégulier. Pour assurer un dépôt régulier sur toute la surface de la tranche, plusieurs pinces 54 et plusieurs zones de contact doivent être prévues. Au moins 6, et de préférence au moins 12, zones de contact et pinces correspondantes seront utilisées pour assurer un dépôt électrolytique régulier de matériau conducteur.

La figure 7 représente la structure à la fin de l'opération de dépôt électrolytique. Le matériau conducteur 26 a été déposé sur une épaisseur suffisante pour remplir la cavité 20. Etant donné que le matériau conducteur 26 se déposera sur toutes les surfaces conductrices exposées, il est possible que du matériau déposé 28 déborde par rapport à la cavité 20 pour former une tête élargie pour le contact 30 ainsi formé. La surface supérieure 32 peut comporter une légère dépression en son centre. Cette forme du contact 30 peut le rendre particulièrement adapté à une utilisation comme plot de liaison.

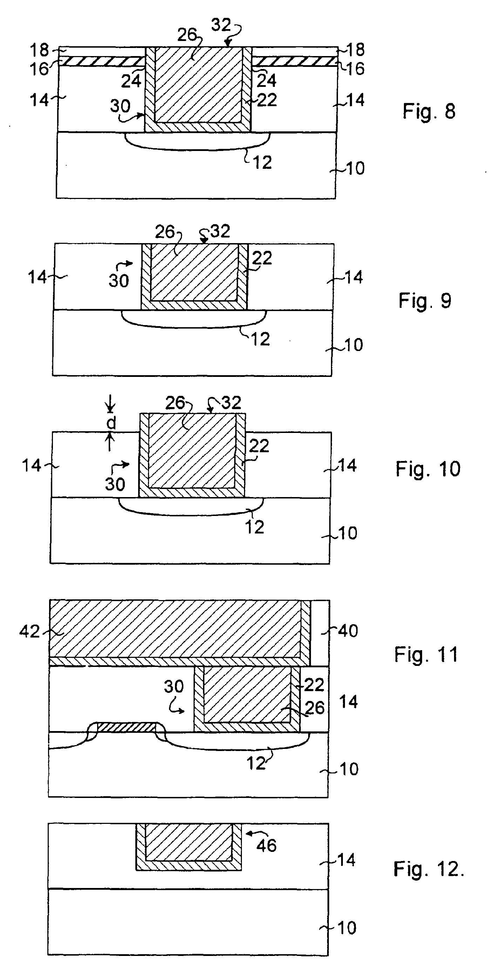

En figure 8, le matériau conducteur 28 déposé à l'extérieur de la cavité est supprimé et le contact 30 est planarisé de sorte que sa surface supérieure est sensiblement coplanaire avec la surface supérieure de la seconde couche diélectrique 18. Ceci peut être réalisé en plongeant la structure dans un bain de gravure humide. La gravure doit être sélective vis-à-vis du matériau de la seconde couche diélectrique 18. Par exemple, si le matériau conducteur 26 est du cuivre, on peut utiliser de l'acide sulfurique dilué. On pourrait également utiliser une étape de polissage mécanique ou mécano-chimique.

La figure 8 représente la structure résultante. Le contact 30 a une surface supérieure 32 sensiblement plane, sensiblement coplanaire avec la surface supérieure de la seconde couche diélectrique 18. Tous les contacts 30 du circuit intégré, ainsi que toutes les régions de contact 12 sont en contact électrique mutuel en raison de la présence de la première couche conductrice 16. Bien évidement le circuit intégré ne pourra pas fonctionner dans cet état. La première couche conductrice 16 a rempli son objet et doit maintenant être supprimée.

La figure 9 représente la structure dans un premier mode de réalisation de l'invention. Une gravure non-selective a été utilisée pour enlever la seconde couche diélectrique 18, la première couche conductrice 16 et une partie du contact 30 à partir de la surface supérieure 32. La structure résultante a une surface supérieure très plane. Une gravure humide, une gravure plasma ou autre gravure sèche peut être utilisée, ou bien encore une étape de polissage mécanique ou mécano-chimique.

Les contacts 30 ont été formés à l'intérieur de la couche diélectrique 14 selon un procédé de type damascène, tout en évitant le besoin d'un polissage mécanique ou mécano-chimique sur une grande épaisseur de matériau conducteur tel qu'un métal. Les inconvénients d'une telle gravure, décrits en relation avec l'art antérieur, sont ainsi évités.

La figure 10 représente une structure selon un deuxième mode de réalisation de la présente invention qui résulte d'une gravure sélective de la seconde couche diélectrique 18 et de la première couche conductrice 16. Cette gravure peut être réalisée en plongeant la structure dans un bain de gravure humide, ou par un procédé de gravure sèche sélective. Si la seconde couche diélectrique 18 est constituée de dioxyde de silicium ou d'un verre à base de dioxyde de silicium, la première couche conductrice 16 d'aluminium, la seconde couche conductrice 22 de nitrure de titane et l'autre matériau conducteur 26 de cuivre, une gravure convenable peut être réalisée en immergeant la structure d'abord dans une solution d'acide fluorhydrique (HF) puis dans une solution de gravure d'aluminium à base d'acide phosphorique (H₃PO₄). La structure résultante est moins plane que la structure de la figure 9, mais la gravure humide peut être effectuée beaucoup plus rapidement que le polissage ou le meulage ionique qui peut être nécessaire pour produire une structure telle que celle représentée en figure 9. Le défaut de planéité de la structure - la hauteur d de la marche - correspond à pas plus que la somme de l'épaisseur de la première couche conductrice 16 et de la seconde couche diélectrique 18. Comme on l'a indiqué précédemment, ceci peut être de l'ordre de 200 nm, ce qui est négligeable par rapport à l'épaisseur de la couche diélectrique 12, quelques 1000 nm.

La figure 11 représente une structure selon un troisième mode de réalisation de l'invention. Le procédé décrit en relation avec les figures 1 à 9 est répété pour une autre couche diélectrique 40. Une couche adaptée d'arrêt de gravure peut être placée entre la première couche diélectrique 14 et l'autre couche diélectrique 40 et toute technique connue dans le procédé simple damascène peut être utilisée pour permettre la gravure d'un motif de connexion dans l'autre couche diélectrique 40. Des connexions 42 sont formées de façon sensiblement coplanaire avec l'autre couche diélectrique 40, ce qui permet d'effectuer une connexion électrique entre plusieurs contacts 30 ou vers des plots de connexion à des broches de boîtier pour le circuit intégré terminé.

La figure 12 représente une structure selon un quatrième mode de réalisation de la présente invention. En arrêtant la gravure exposée en relation avec la figure 2 avant que la couche 10 sous-jacente ne soit exposée, on forme une cavité s'étendant partiellement à travers la première couche diélectrique 14. Puisque le revêtement de cavité 22 (figure 4) est électriquement connecté par la première couche conductrice 16 près de l'extrémité supérieure de la cavité, une telle cavité de profondeur partielle est remplie de la même façon qu'une cavité de profondeur complète. Une connexion 46, isolée de la couche sous-jacente, peut alors être créée. En prévoyant des étapes adaptées de masquage différentiel et de gravure, des connexions 46 et des contacts 30 peuvent être formés dans une seule et même couche diélectrique.

## Revendications

1. Procédé de formation d'éléments conducteurs dans un circuit intégré comprenant les étapes successives suivantes :
a) prévoir une couche sous-jacente (10) ayant une surface supérieure ;
b) déposer une première couche diélectrique (14) sur la surface supérieure de la couche sous-jacente ;
c) déposer une première couche conductrice (16) sur la surface supérieure de la première couche diélectrique ; et
d) déposer une seconde couche diélectrique (18) sur la première couche conductrice ;
e) former des cavités (20) traversant la première couche conductrice (16) et la seconde couche diélectrique 18) et s'étendant au moins partiellement à travers la première couche diélectrique (14) à des emplacements (12) choisis pour la formation d'éléments conducteurs ; et
f) former une seconde couche conductrice (22) sur toutes les surfaces internes des cavités ; et
g) déposer électrolytiquement un autre matériau conducteur (26) sur la seconde couche conductrice pour remplir les cavités.

2. Procédé selon la revendication 1, dans lequel l'autre matériau conducteur est déposé selon une épaisseur suffisante pour remplir sensiblement les cavités.

3. Procédé selon la revendication 1, dans lequel l'étape f) comprend les étapes suivantes :
déposer une seconde couche conductrice (22) sur toutes les surfaces exposées de la structure ; et
enlever la seconde couche conductrice de toute les surfaces de la structure autre que les surfaces internes des cavités.

4. Procédé selon la revendication 3, dans lequel la seconde couche conductrice (22) est enlevée par une étape de polissage.

5. Procédé selon la revendication 1, comprenant en outre, après l'étape g), l'étape consistant à polir la surface supérieure de la structure pour enlever le matériau conducteur (28) en excès faisant saillie au-dessus de la surface supérieure de la seconde couche diélectrique.

6. Procédé selon la revendication 1, comprenant en outre après l'étape g), l'étape consistant à polir la surface supérieure de la structure pour enlever le matériau conducteur faisant saillie au-dessus de la surface supérieure de la première couche diélectrique (14) et pour enlever complètement la seconde couche diélectrique et la première couche conductrice.

7. Procédé selon la revendication 1, dans lequel la couche sous-jacente (10) est une couche conductrice ou semiconductrice et les cavités (20) s'étendent complètement à travers la première couche diélectrique (14), d'où il résulte que l'élément conducteur résultant est en contact avec la couche conductrice ou semiconductrice sous-jacente (12).

8. Procédé selon la revendication 1, dans lequel les cavités (20) s'étendent seulement partiellement à travers la première couche diélectrique (14), l'élément conducteur résultant (46) étant isolé électriquement de la couche sous-jacente (10).

9. Procédé selon la revendication 1, dans lequel la couche sous-jacente est une couche diélectrique (14) comprenant des éléments de contact (30) qui la traversent verticalement, les cavités s'étendant complètement à travers la première couche diélectrique, d'où il résulte que les éléments conducteurs résultant (42) sont des interconnexions électriquement en contact avec les éléments de contact sous-jacents.

## Claims

1. A method of forming conductive members in an integrated circuit comprising the successive steps of:
a) providing an underlying layer (10), having an upper surface;
b) depositing a first dielectric layer (14) on the upper surface of the underlying layer;
c) depositing a first conductive layer (16) on an upper surface of the first dielectric layer;
d) depositing a second dielectric layer (18) on the first conductive layer;
e) forming cavities (20) extending through the first conductive layer (16) and the second dielectric layer (18) and extending at least partially through the first dielectric layer (14) in locations (12) selected for the formation of the conductive members; and
f) forming a second conductive layer (22) on all internal surfaces of the cavities; and
g) electrolytically depositing a further conductive material (26) over the second conductive layer to fill the cavities.

2. A method according to claim 1, wherein the further conductive material is deposited to a thickness sufficient to substantially fill the cavities.

3. A method according to claim 1, wherein step (f) comprises the steps of:
depositing a second conductive layer (22) over all exposed surfaces of the structure; and
removing the second conductive layer from all surfaces of the structure other than the internal surfaces of the cavities.

4. A method according to claim 3, wherein the second conductive layer (22) is removed by a polishing process step.

5. A method according to claim 1, further including, after step (g), the step of polishing the upper surface of the structure to remove excess conductive material (28) protruding above an upper surface of the second dielectric layer.

6. A method according to claim 1, further including, after step (g), the step of polishing the upper surface of the structure to remove conductive material protruding above the upper surface of the first dielectric layer (14), and to entirely remove the second dielectric layer and the first conductive layer.

7. A method according to claim 1, wherein the underlying layer (10) is a conductive or semiconductive layer, and the cavities (20) extend completely through the first dielectric layer (14), whereby the resulting conductive member is in contact with the underlying conductive or semiconductive layer (12).

8. A method according to claim 1, wherein the cavities (20) extend only partially through the first dielectric layer (14), the resulting conductive member (46) being electrically isolated from the underlying layer (10).

9. A method according to claim 1, wherein the underlying layer is a dielectric layer (14) including contact members (30) extending vertically therethrough, the cavities extending completely through the first dielectric layer, whereby the resulting conductive members (42) are interconnect wirings, electrically in contact with the underlying contact members.

## Patentansprüche

1. Ein Verfahren zur Bildung leitender Glieder in einer integrierten Schaltung, wobei die folgenden aufeinanderfolgenden Schritte vorgesehen sind:
a) Vorsehen einer darunterliegenden Schicht (10) mit einer oberen Oberfläche;
b) Abscheiden einer ersten dielektrischen Schicht (14) auf der oberen Oberfläche der darunterliegenden Schicht;
c) Abscheiden einer ersten leitenden Schicht (16) auf einer oberen Oberfläche der ersten dielektrischen Schicht;
d) Abscheiden einer zweiten dielektrischen Schicht (18) auf der ersten leitenden Schicht;
e) Bilden von Hohlräumen (20), die sich durch die erste leitende Schicht (16) und die zweite dielektrische Schicht (18) erstrecken, und die sich mindestens teilweise durch die erste dielektrische Schicht (14) an Stellen (12) erstrecken, die ausgebildet sind für die Bildung der leitenden Glieder; und
f) Bilden bzw. Formen einer zweiten leitenden Schicht (22) auf sämtlichen internen Oberflächen der Hohlräume; und
g) elektrolytisches Abscheiden eines weiteren leitenden Materials (26) über der zweiten leitenden Schicht um die Hohlräume zu füllen.

2. Verfahren nach Anspruch 1, wobei das weitere leitende Material in einer Dicke abgeschieden wird, die ausreicht um die Hohlräume im Wesentlichen anzufüllen

3. Verfahren nach Anspruch 1, wobei der Schritt (f) die folgenden Schritte aufweist:
Abscheiden einer zweiten leitenden Schicht (22) über sämtliche freigelegte Oberflächen der Struktur; und
Entfernen der zweiten leitenden Schicht von allen Oberflächen der Struktur, die nicht die Innenoberflächen der Hohlräume bilden.

4. Verfahren nach Anspruch 3, wobei die zweite leitende Schicht (22) durch einen Polierprozessschritt entfernt wird.

5. Verfahren nach Anspruch 1, wobei ferner Folgendes vorgesehen ist:
darauf folgend auf den Schritt (g) den Schritt des Polierens der oberen Oberfläche der Struktur zur Entfernung von überschüssigem leitenden Material (28), welches über eine obere Oberfläche der zweiten elektrischen Schicht hinausragt.

6. Verfahren nach Anspruch 1, wobei ferner nach dem Schritt (g) der Schritt des Polierens der oberen Oberfläche der Struktur vorgesehen ist, und zwar zur Entfernung leitenden Materials, welches über die obere Oberfläche der ersten dielektrischen Schicht (14) hinausragt, und um die zweite dielektrische Schicht und die erste leitende Schicht vollständig zu entfernen.

7. Verfahren nach Anspruch 1, wobei die darunterliegende Schicht (10) eine leitende oder eine halbleitende Schicht ist, und wobei die Hohlräume (20) sich vollständig durch die erste dielektrische Schicht (14) erstrecken, wodurch das sich ergebende leitende Glied in Kontakt mit der darunterliegenden leitenden oder halbleitenden Schicht (12) steht.

8. Verfahren nach Anspruch 1, wobei die Hohlräume (20) sich nur teilweise durch die erste dielektrische Schicht (14) erstrecken, wobei das sich ergebende leitende Glied (46) elektrisch von der darunterliegenden Schicht (10) isoliert ist.

9. Verfahren nach Anspruch 1, wobei die darunterliegende Schicht eine dielektrische Schicht (14) ist, einschließlich Kontaktgliedern (30), die sich vertikal dahindurch erstrecken, wobei die Hohlräume sich vollständig durch die erste dielektrische Schicht erstrecken, und wobei ferner die sich ergebenden leitenden Glieder (42) eine Zwischenverbindungsverdrahtung bilden, und zwar in elektrischem Kontakt mit den darunterliegenden Kontaktgliedern.
